# EUROPÄISCHE PATENTSCHRIFT

(11) **EP 1 762 001 B1**
(45) Veröffentlichungstag und Bekanntmachung des Hinweises auf die Patenterteilung: **01.12.2010**
(21) Anmeldenummer: 05756811.5
(22) Anmeldetag: 01.06.2005
(51) Int. Cl.: H02P 7/28, H02H 7/08, H02K 9/06, H02K 11/04, G01R 19/165, H02H 9/02, H03K 17/082

(54) **SCHALTUNGSANORDNUNG UND VERFAHREN ZUR EINSTELLUNG DER LEISTUNGSAUFNAHME EINER AN EINEM GLEICHSPANNUNGSNETZ BETREIBBAREN LAST**
CIRCUIT ARRANGEMENT AND METHOD FOR ADJUSTING THE POWER INPUT OF A LOAD WHICH CAN BE OPERATED ON A DIRECT CURRENT SUPPLY NETWORK
ENSEMBLE CIRCUIT ET PROCEDE D'AJUSTEMENT DU PRELEVEMENT DE COURANT D'UNE CHARGE POUVANT FONCTIONNER SUR UN RESEAU DE TENSION CONTINUE

(30) Priorität: 22.06.2004 DE 102004030129
(43) Veröffentlichungstag der Anmeldung: 14.03.2007
(73) Patentinhaber: ROBERT BOSCH GMBH, 70442 Stuttgart (DE)
(72) Erfinder: KNAB, Norbert, 77767 Appenweier (DE); HABERL, Nikolas, 77886 Lauf (DE); KOERNER, Michael, 77815 Buehl-Altschweier (DE)
(86) Internationale Anmeldenummer: PCT/EP2005/052496
(87) Internationale Veröffentlichungsnummer: WO 2005/124991

(56) Entgegenhaltungen:
- WO-A-2004/051832
- DE-A1- 4 209 167
- DE-A1- 4 329 919

## Beschreibung

### Stand der Technik

Die Erfindung geht aus von einer Schaltungsanordnung und einem Verfahren zur Einstellung der Leistungsaufnahme einer an einem Gleichspannungsnetz betreibbaren Last, insbesondere eines Kühlgebläsemotors eines Kraftfahrzeuges, nach dem Oberbegriff der unabhängigen Ansprüche 1 und 2.

Aus der DE 100 44 388 A ist eine Schaltungsanordnung zum Ein- und Ausschalten eines am Bordnetz eines Kraftfahrzeuges betreibbaren Gleichstrommotors mit großer Motorleistung bekannt, der über einen Halbleiterschalter mit zugeordneter Steuereinheit an das Gleichstromnetz anschließbar ist. Hierbei wird zur thermischen Entlastung des Halbleiterschalters nach dem Abklingen des Einschaltstromes der Halbleiterschalter durch einen Relaiskontakt überbrückt. Eine Erfassung und Überwachung des Motorstromes ist mit der bekannten Anordnung nicht möglich.

Die DE 43 29 919 A1 zeigt eine Vorrichtung zur Ansteuerung eines Verbrauchers in einem Fahrzeug, mit wenigestens zwei als so genannte Currentsense-MOTFET ausgebildeten Schaltelementen zur Beeinflussung des Stromflusses durch den Verbraucher, wobei für jedes Schaltelement der durch dieses Schaltelement fließende Strom überwacht und zur Kurzschlusserkennung ausgewertet wird.

Weiterhin ist aus der DE 196 48 710 C eine Schaltungsanordnung bekannt, welche den Elektromotor des Kühlgebläses einer Brennkraftmaschine einerseits über einen Strompfad mit Vorwiderstand und andererseits über einen Strompfad ohne Vorwiderstand direkt mit der Stromversorgung verbindet zur zweistufigen Ansteuerung des Elektromotors mit unterschiedlichen Drehzahlen. Die Umschaltung der Ansteuerung erfolgt durch eine Steuereinheit, welche den Elektromotor über eine der beiden Zuleitungen mit der Spannungsquelle verbindet. Zusätzlich ist in dem Stromkreis mit Vorwiderstand eine Mikrotemperatursicherung angeordnet, welche bei unzulässig hohem Anstieg des Stromes über den Vorwiderstand diesen Stromkreis unterbricht. Die Steuereinheit für die Umschaltung der Strompfade erhält keine Rückmeldung über die jeweilige Höhe des Speisestromes für den Elektromotor.

Der Erfindung liegt die Aufgabe zugrunde, eine Schaltungsanordnung und ein Verfahren zur Einstellung der Leistungsaufnahme einer an einem Gleichspannungsnetz betreibbaren Last, insbesondere eines Gleichstrommotors, dahingehend zu verbessern, dass zumindest der oder die thermisch kritischen Speisestromkreise der Last hinsichtlich der eingespeisten Leistung mit möglichst geringem Aufwand überwacht und durch rechtzeitige Abschaltung eine thermische Überlastung der Anordnung vermieden wird.

Diese Aufgabe wird gelöst durch die kennzeichnenden Merkmale des Anspruchs 1, wobei durch die Verwendung eines Sense-Feldeffekttransistors (Sense-FET) als Schaltelement in mindestens einem Speisestromkreis der Last und durch die Auswertung des erfassten Stromwertes durch die Ansteuerelektronik der Schaltungsanordnung sowohl in schaltungstechnischer als auch in baulicher Hinsicht eine besonders einfache und vorteilhafte Lösung zur Überwachung des Arbeitspunktes der Last geschaffen wird. Die erfindungsgemäße Schaltungsanordnung und das zugehörige Verfahren nach Anspruch 2 sind insbesondere dort von Vorteil, wo große Lasten, beispielsweise große Gleichstrommotoren, an ein Gleichspannungsnetz angeschaltet und thermische Überlastungen, beispielsweise durch das Blockieren eines Motors oder durch Überhitzung eines Vorwiderstandes für einen derartigen Motor vermieden werden müssen.

Bei der Verwendung der erfindungsgemäßen Schaltungsanordnung und des zugehörigen Verfahrens zum Betreiben eines leistungsstarken Gleichstrommotors an einem Gleichspannungsnetz ergibt sich eine vorteilhafte Ausgestaltung der Erfindung, wenn der Motor zur Einstellung unterschiedlicher Drehzahlen durch die Steuereinheit wahlweise über wenigstens einen Vorwiderstand und wenigstens einen Sense-FET oder über einen weiteren Halbleiterschalter, vorzugsweise in Form eines "normalen" Feldeffekttransistors, und einen Strompfad ohne vorwiderstand mit dem Gleichspannungsnetz verbunden wird. Die Einschaltung eines leistungsstarken Gleichstrommotors geschieht dabei stets über einen Stromkreis mit Vorwiderstand und Sense-FET zur Begrenzung und Überwachung der Leistungsaufnahme des Motors. Die Umschaltung der Stromversorgung für den Motor auf einen anderen Speisestromkreis ohne Vorwiderstand zur Einstellung einer höheren Drehzahl erfolgt erst nach dem Abklingen des Einschaltstromes und nach Erreichen der niedrigeren Drehzahl entsprechend dem durch den Vorwiderstand reduzierten Motorstrom, sodass beispielsweise eine Blockierung des Motors ohne zusätzlichen Schaltungsaufwand aus der mit dem Sense-FET messbaren Stromaufnahme sofort erkennbar ist.

Weitere Einzelheiten und Ausgestaltungen der Erfindung ergeben sich aus den Unteransprüchen und der Beschreibung eines Ausführungsbeispiels der Erfindung.

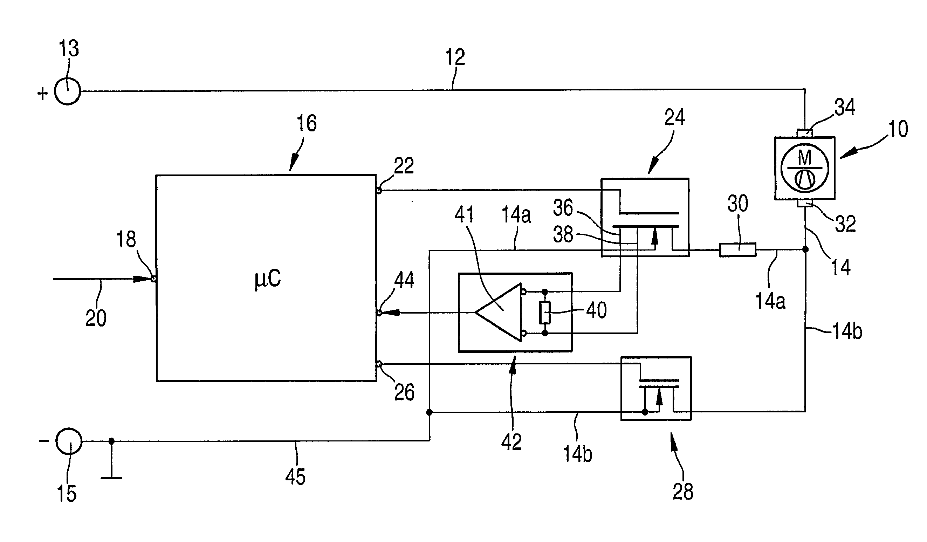

Die Figur zeigt eine Schaltungsanordnung zur Einstellung und Überwachung der Leistungsaufnahme eines an einem Gleichspannungsnetz betriebenen Kühlgebläsemotors mit zwei Drehzahlstufen.

In der Zeichnung ist ein permanentmagnetisch erregter Gleichstrommotor mit integriertem Kühlgebläse mit 10 bezeichnet. Der Motor ist über eine Leitung 12 mit dem Pluspol 13 und über Leitungen 14, 14a, 14b und 45 mit dem Minuspol 15 einer Gleichstromquelle verbunden. Im Zuge der Leitung 14a liegt ein Sense-FET 24 und ein Widerstand 30, im Zuge der Leitung 14b ein FET 28. Das Gleichspannungsnetz wird hier gebildet durch das Bordnetz eines Kraftfahrzeuges mit einer Versorgungsspannung von ca.13 V. Der die Last bildende Gleichstrommotor 10 ist bei der Koppelung mit einem Kühlerlüfter eines Kraftfahrzeuges je nach Größe des Kraftfahrzeugmotors für einen Nennstrom von etwa 10 bis 50 A ausgelegt. Der Kurzschlussstrom eines derartigen Motors im Blockierfall erreicht etwa den vierfachen Wert des Nennstromes.

Zur Ansteuerung des Gleichstrommotors 10 dient eine Steuereinheit 16, beispielsweise in Form eines Mikrocontrollers, welche an ihrem Eingang 18 ein Steuersignal 20 erhält, das aus mehreren relevanten Kenngrößen für den Kühlungsbedarf des Kraftfahrzeugmotors gebildet wird, insbesondere durch die Kühlmitteltemperatur, die Drehzahl des Kraftfahrzeugmotors und die Fahrzeuggeschwindigkeit sowie durch den Kühlbedarf bei eingeschalteter Klimaanlage.

Im dargestellten Ausführungsbeispiel ist die Motorsteuerung zweistufig ausgelegt, wobei ein erster Ausgang 22 der Steuereinheit 16 mit der Gate Elektrode eines Sense-FET 24 und ein zweiter Ausgang 26 der Steuereinheit 16 mit der Gate-Elektrode eines "normalen" Feldeffekttransistors, insbesondere eines MOSFETs, verbunden ist. Die Drain-Elektrode des Sense-FET 24 ist über einen Vorwiderstand 30 von etwa 0,1 bis 1 Ω und die Leitungen 14a, 14 mit der dem Minuspol 15 des Gleichspannungsnetzes zugewandten Motorkontaktierung 32 verbunden, die Source-Elektrode des Sense-FET 24 liegt über die Leitungen 14a und 45 an dem mit Masse verbundenen Minuspol 15 des Gleichspannungsnetzes. Die Messausgänge des Sense-FET 24 sind mit 36 und 38 bezeichnet. Über diese Ausgänge fließt ein definierter Teilstrom des von dem Sense-FET 24 geführten Laststromes, welcher an einem Widerstand 40 einer Auswerteschaltung 42 für das Sense-Signal einen Spannungsabfall erzeugt, der wiederum über einen Operationsverstärker 41 einem Eingang 44 der Steuereinheit 16 zugeführt wird. Die dem Minuspol 15 des Gleichspannungsnetzes zugeordnete Motorkontaktierung 32 ist weiterhin über die Leitungen 14, 14b, die Drain-Source-Strecke des MOSFET 28 und die Leitung 45 direkt mit dem Minuspol 15 des Gleichspannungsnetzes und mit Masse verbunden.

Die Schaltungsanordnung arbeitet folgendermaßen:
Das Einschalten des Gleichstrommotors 10 erfolgt nach Bedarf entsprechend dem Wärmeanfall im Kühlsystem des nicht dargestellten Kraftfahrzeugmotors, sobald am Eingang 18 der Steuereinheit 16 ein Einschaltsignal 20 ansteht. Die Steuereinheit 16 erzeugt dann ein Signal zum Durchschalten des Sense-FET 24, welches über ihren Ausgang 22 an der Gate-Elektrode des Sense-FET 24 während der Dauer des Motorbetriebes mit der niedrigeren Drehzahl anliegt. Der Gleichstrommotors 10 wird also nicht getaktet sondern im Dauerbetrieb eingeschaltet und zwar unabhängig vom Kühlbedarf jeweils zunächst über den Vorwiderstand 30. Der Gleichstrommotor 10 arbeitet in einem vorgegebenen Lastbereich, die Steuereinheit 16 erkennt über das laststromabhängige Signal der Auswerteschaltung 42 an ihrem Eingang 44 einen regulären Arbeitspunkt des Gleichstrommotors 10 und dieser bleibt eingeschaltet, solange das Steuersignal 20 am Eingang 18 der Steuereinheit 16 anliegt. Ist dagegen die Leistungsaufnahme des Gleichstrommotors 10 zu hoch, beispielsweise durch ein mechanisches Blockieren des Motors oder des Lüfters oder durch sonstige irreguläre äußere Bedingungen, so steigt der an den Messausgängen 36 und 38 des Sense-FET 24 abgegriffene Messstrom über einen vorgebbaren Schwellwert an und die Steuereinheit 16 erkennt das Signal an ihrem Eingang 44 als Fehler. Diese Fehlermeldung wird dann in der Steuereinheit 16 bewertet, entweder bei entsprechend hohem Strom über den Sense-FET 24 als Blockierung des Motors oder beispielsweise als Überlastung und demzufolge mögliche Überhitzung des Vorwiderstandes 30. Wenn eine derartige Überlastung erkannt wird, wird der Gleichstrommotor 10 vom Gleichspannungsnetz 13, 15 abgetrennt. Bei höherem Kühlungsbedarf schaltet die Steuereinheit 16 um auf einen Betrieb des Gleichstrommotors 10 ohne Vorwiderstand und demzufolge erhöhter Motordrehzahl mit direktem Anschluss des Gleichstrommotors 10 an den Minuspol 15 des Gleichspannungsnetzes über den MOSFET 28.

Die Schaltungsanordnung und das für die Einstellung der Leistungsaufnahme der angeschlossenen Last verwendete Verfahren können in verschiedener Weise ausgestaltet sein. Eine häufig verwendete Anordnung ist beim Ausführungsbeispiel für einen Gleichstrommotor mit zwei unterschiedlichen Drehzahlen dargestellt. Eine oder mehrere Drehzahlstufen können hinzugefügt werden, indem der Gleichstrommotor 10 über unterschiedlich große Vorwiderstände eingeschaltet wird, wobei als Schaltelemente entweder ein Sense-FET mit der Möglichkeit der Stromüberwachung oder ein "normaler" Feldeffekttransistor einsetzbar sind. Selbstverständlich kann auch die höchste Drehzahlstufe bei Anschluss des Gleichstrommotors 10 ohne Vorwiderstand mit Stromüberwachung durch einen Sense-FET erfolgen.

Mit der erfindungsgemäßen Schaltung werden herkömmliche mehrstufige Schaltungen zum Anschluss von insbesondere induktiven Lasten an ein Gleichspannungsnetz dahingehend verbessert, dass mechanische Teile von Relais vollständig entfallen und Halbleiterschalter besonders verlustarm eingesetzt werden können bei gleichzeitiger Schaffung einer Überwachungsmöglichkeit des Arbeitspunktes der angeschlossenen Last. Bei einer ungetakteten Betriebsform der angeschlossenen Last ist die Verlustleistung in den Halbleiterschaltern gering und es ist nur eine geringe Kühlung der Schaltelemente erforderlich. Außerdem entfällt in dieser Anwendungsform die bei Taktung entstehende Geräuschentwicklung und die elektromagnetische Verträglichkeit wird verbessert. Wird die Erkennung eines Störfalles, beispielsweise die Blockiererkennung eines Gleichstrommotors, nur in dessen kleinster Drehzahlstufe vorgenommen, so fließt über den in dieser Drehzahlstufe eingeschalteten Sense-FET 24 nur ein relativ geringer Strom und der Sense-FET kann dadurch einen höheren Widerstand seiner Drain-Source-Strecke ( RDSon ) aufweisen und verursacht somit geringere Kosten. Die Blockiererkennung erfolgt hierbei über eine Strommessung in besonders einfacher und vorteilhafter Weise, wobei der hohe Strom eines blockierten Gleichstrommotors erkennbar ist, da er wesentlich über dem Betriebsstrom des Motors liegt. Die Auswertung des Sense-Signals in der Auswerteschaltung 42 kann bei ungetaktetem Betrieb sehr einfach vorgenommen werden, da es sich um ein Gleichspannungssignal handelt.

## Patentansprüche

1. Schaltungsanordnung zur Einstellung der Leistungsaufnahme einer an einem Gleichspannungsnetz (13, 15) betreibbaren Last (10), insbesondere eines Kühlgebläsemotors (10) eines Kraftfahrzeuges, mit wenigstens einem Halbleiterschalter (24, 28) im Speisestromkreis (12, 14, 14a, 14b) der Last (10), sowie mit einer Steuereinheit (16) zum Ansteuern des oder der Halbleiterschalter (24, 28), wobei die Last (10) über wenigstens einen Sense-FET (24) an das Gleichspannungsnetz (13, 15) anschließbar ist, ein Messausgang (36, 38) des Sense-FET (24) mit der Steuereinheit (16) verbunden ist und dieser ein Signal entsprechend der Stromaufnahme der Last (10) im jeweiligen Arbeitspunkt liefert, **dadurch gekennzeichnet, dass** die Last (10) wahlweise über wenigstens einen Vorwiderstand (30) und den wenigstens einen Sense-FET (24) oder über einen weiteren Halbleiterschalter (28) und einen Strompfad (14b) ohne Vorwiderstand mit dem Gleichspannungsnetz (13, 15) aufgrund der von dem Sense-FET (24) gelieferten Messwerte verbunden wird, wobei die beiden Halbleiterschalter (24, 28) jeweils durchgeschaltet betrieben werden.

2. Verfahren zur Einstellung der Leistungsaufnahme einer an einem Gleichspannungsnetz (13, 15) betreibbaren Last (10), insbesondere eines Kühlgebläsemotors (10) eines Kraftfahrzeuges, mit wenigstens einem Halbleiterschalter (24, 28) im Speisestromkreis (12, 14, 14a, 14b) der Last (10), sowie mit einer Steuereinheit (16) zum Ansteuern des oder der Halbleiterschalter (24, 28), wobei die Last (10) über wenigstens einen Sense-FET (24) an das Gleichspannungsnetz (13, 15) anschließbar ist, über Mess-Anschlüsse (36, 38) des Sense-FET (24) die Stromaufnahme der Last (10) im jeweiligen Arbeitspunkt gemessen und hieraus ein Signal für die Steuereinheit (16) erzeugt wird, **dadurch gekennzeichnet, dass** die Steuereinheit (16) aufgrund der von dem Sense-FET (24) gelieferten Messwerte bei Überschreitung einer vorgebbaren Schwelle des Speisestromes von einem Speisestromkreis (14a) mit Vorwiderstand (30) auf einen Speisestromkreis (14b) ohne Vorwiderstand umschaltet,
wobei die beiden Halbleiterschalter (24, 28) jeweils durchgeschaltet betrieben werden.

3. Verfahren nach Anspruch 2, **dadurch gekennzeichnet, dass** bei einer mehrstufigen Ausbildung des Speisestromkreises (12, 14, 14a, 14b) die Last (10) über den Stromkreis (14a) mit dem Vorwiderstand (30) und dem Sense-FET (24) eingeschaltet wird.

4. Verfahren nach Anspruch 2 oder 3, **dadurch gekennzeichnet, dass** als Last (10) ein permanentmagnetisch erregter Gleichstrommotor (10) über die getrennt ansteuerbaren Halbleiterschalter (24, 28) ungetaktet an das Gleichspannungsnetz (13, 15) angeschlossen wird.

5. Verfahren nach Anspruch 4, **dadurch gekennzeichnet, dass** durch die Steuereinheit (16) aufgrund der von dem Sense-FET (24) gelieferten Messwerte das Auftreten einer Blockierung des angeschlossenen Gleichstrommotors (10) überwacht und gegebenenfalls die Stromversorgung des Motors (10) unterbrochen wird.

## Claims

1. Circuit arrangement for adjusting the power consumption by a load (10), in particular a cooling fan motor (10) of a motor vehicle, which can be operated using a DC voltage power supply system (13, 15), the said circuit arrangement having at least one semiconductor switch (24, 28) in the feed circuit (12, 14, 14a, 14b) of the load (10), and having a control unit (16) for driving the semiconductor switch or switches (24, 28), it being possible for the load (10) to be connected to the DC voltage power supply system (13, 15) via at least one sense-FET (24), a measurement output (36, 38) of the sense-FET (24) being connected to the control unit (16) and supplying the said control unit with a signal corresponding to the power consumption of the load (10) at the respective operating point, **characterized in that** the load (10) is connected to the DC voltage power supply system (13, 15) selectively via at least one series resistor (30) and the at least one sense-FET (24) or via a further semiconductor switch (28) and a current path (14b) without a series resistor on the basis of the measurement values supplied by the sense-FET (24), the two semiconductor switches (24, 28) each being operated in the turned-on state.

2. Method for adjusting the power consumption by a load (10), in particular a cooling fan motor (10) of a motor vehicle, which can be operated using a DC voltage power supply system (13, 15), having at least one semiconductor switch (24, 28) in the feed circuit (12, 14, 14a, 14b) of the load (10), and having a control unit (16) for driving the semiconductor switch or switches (24, 28), it being possible for the load (10) to be connected to the DC voltage power supply system (13, 15) via at least one sense-FET (24), the power consumption by the load (10) at the respective operating point being measured via measurement connections (36, 38) of the sense-FET (24) and a signal for the control unit (16) being generated from this, **characterized in that** the control unit (16) switches over from a feed circuit (14a) with a series resistor (30) to a feed circuit (14b) without a series resistor on the basis of the measurement values supplied by the sense-FET (24) when a predefinable threshold of the feed current is exceeded, the two semiconductor switches (24, 28) each being operated in the turned-on state.

3. Method according to Claim 2, **characterized in that** the load (10) is switched on via the circuit (14a) with the series resistor (30) and the sense-FET (24) when the feed circuit (12, 14, 14a, 14b) is of multi-stage design.

4. Method according to Claim 2 or 3, **characterized in that**, as the load (10), a DC motor (10) with permanent-magnet excitation is connected in an unpulsed manner to the DC voltage power supply system (13, 15) via the semiconductor switches (24, 28) which can be driven separately.

5. Method according to Claim 4, **characterized in that** the occurrence of blocking of the connected DC motor (10) is monitored and the power supply to the motor (10) is possibly interrupted by the control unit (16) on the basis of the measurement values supplied by the sense-FET (24).

## Revendications

1. Circuit destiné à régler la puissance consommée par une charge (10) alimentée par un réseau (13, 15) à tension continue, en particulier par le moteur (10) d'un ventilateur de refroidissement d'un véhicule automobile, et présentant au moins un commutateur semi-conducteur (24, 28) dans le circuit (12, 14, 14a, 14b) d'alimentation en courant de la charge (10) ainsi qu'une unité de commande (16) qui commande le ou les commutateurs semi-conducteurs (24, 28), la charge (10) pouvant être raccordée au réseau (13, 15) à tension continue par au moins un sense - FET (24), une sortie de mesure (36, 38) du sense - FET (24) étant reliée à l'unité de commande (16) et délivrant à cette dernière un signal qui correspond à la consommation de courant de la charge (10) en chaque point de travail, **caractérisé en ce que** la charge (10) est reliée sélectivement au réseau (13, 15) à tension continue par au moins une pré-résistance (30) et le ou les sense - FET (24) ou par un autre commutateur semi-conducteur (28) et un parcours de courant (14b) sans pré-résistance sur la base des valeurs de mesure délivrées par le sense - FET (24), les deux commutateurs semi-conducteurs (24, 28) travaillant chacun en mode passant.

2. Procédé pour régler la puissance consommée par une charge (10) alimentée par un réseau (13, 15) à tension continue, en particulier par le moteur (10) d'un ventilateur de refroidissement d'un véhicule automobile, et présentant au moins un commutateur semi-conducteur (24, 28) dans le circuit (12, 14, 14a, 14b) d'alimentation en courant de la charge (10) ainsi qu'une unité de commande (16) qui commande le ou les commutateurs semi-conducteurs (24, 28), la charge (10) pouvant être raccordée au réseau (13, 15) à tension continue par au moins un sense - FET (24), la consommation de courant de la charge (10) à chaque point de travail étant mesurée par des bornes de mesure (36, 38) du sense - FET (24) et un signal étant formé à partir de là pour l'unité de commande (16),
**caractérisé en ce que** sur la base des valeurs de mesure délivrées par le sense - FET (24), en cas de dépassement d'un seuil prédéterminé du courant d'alimentation, l'unité de commande (16) bascule d'un circuit (14a) d'alimentation en courant à pré-résistance (30) à un circuit (14b) d'alimentation en courant sans pré-résistance, les commutateurs semi-conducteurs (24, 28) travaillant tous deux en mode passant.

3. Procédé selon la revendication 2, **caractérisé en ce que** lorsque le circuit (12, 14, 14a, 14b) d'alimentation en courant est configuré en plusieurs étages, la charge (10) est branchée par l'intermédiaire du circuit de courant (14a) qui présente la pré-résistance (30) et le sense - FET (24).

4. Procédé selon la revendication 2 ou 3, **caractérisé en ce que** la charge (10) raccordée est un moteur (10) à courant continu excité par aimant permanent, raccordé sans cadençage au réseau (13, 15) à tension continue par l'intermédiaire des commutateurs semi-conducteurs (24, 28) qui peuvent être commandés séparément.

5. Procédé selon la revendication 4, **caractérisé en ce que** sur la base des valeurs de mesure délivrées par le sense - FET (24), l'unité de commande (16) surveille l'apparition d'un blocage du moteur (10) à courant continu qui y est raccordé et interrompt éventuellement l'alimentation en courant du moteur (10).
